# EUROPEAN PATENT APPLICATION

(11) **EP 1 074 844 A2**
(43) Date of publication of application: **07.02.2001**
(21) Application number: 00306270.0
(22) Date of filing: 24.07.2000
(51) Int. Cl.: G01R 1/073

(54) **Testing integrated circuits**

(30) Priority: 03.08.1999 US 366523
(71) Applicant: LUCENT TECHNOLOGIES INC., Murray Hill, New Jersey 07974-0636 (US)
(72) Inventor: Ahlquist, Louis Nelson, Annandale, NJ 08801 (US); Degani, Yinon, Highland Park, NJ 08904 (US); Jacala, Jericho J., Murray Hill, NJ 07974 (US); Kossives, Dean Paul, Glen Gardner, NJ 08826 (US); Tai, King Lien, Berkeley Heights, NJ 07922 (US)
(74) Representative: Buckley, Christopher Simon Thirsk

(57) **Abstract**

The specification describes IC devices with arrays of solder ball interconnections in which the balls are reshaped to produce flattened surfaces to improve contact of the array with a test or interconnection substrate. Techniques described to flatten the balls include cutting away the surface of the balls using a dicing saw. Alternatively, the solder balls are softened or melted and reshaped on a non-wetting planar surface, or molded with a non-wetting mold. The reshaped balls are especially well suited for testing with a sockets test bed. In a preferred embodiment the sockets are formed by pairs of intersecting V-grooves, whereby pyramid shaped features are produced at the bottom of each socket. The sharp points of the pyramid(s) provides contact enhancement between the flattened solder bumps and the test bed. The sockets of the test bed can be provided with through holes to interconnect the solder bumps to the next board level with minimum electrical path length thereby reducing parasitic capacitive coupling.

## Description

### Field Of The Invention

This invention relates to methods for making solder ball or solder bump IC devices. More specifically it relates to techniques for shaping previously formed solder balls to adapt them for testing or packaging.

### Background Of The Invention

Testing of semiconductor devices is typically conducted with apparatus constructed on the "bed of nails" principle. This type of test equipment is highly developed and widely used. However, as the pitch of IC devices shrinks, it becomes difficult to reliably access the contact pads on the IC device. The difficulty is not only accessing a small array of contacts, but the contact resistance varies significantly from pin to pin, and is not only accessing a small array of contacts, but the contact resistance varies significantly from pin to pin, and is sometimes excessive. Improvements in test equipment for solder bump arrays have been made. One example is the use of a silicon test bed in which a pattern of recesses is etched into a silicon wafer, and each recess is interconnected to a test circuit that simulates the device circuit. The array of recesses is matched to the solder ball array on the IC device. The use of silicon as the test bed offers the advantages of high planarity, thermal properties that match the IC substrate, notably coefficient of thermal expansion, and the availability of a well developed interconnect technology for fabricating the test circuit.

The terms solder balls and solder bumps are used variously herein but in the context of the invention are essentially interchangeable. They are intended to describe solder formations that are melted during the process for making the solder ball/bump array ont he IC chip and, due to the action of surface tension, form into an essentially spherical shape.

Regardless of how planar the test bed is made, irregularities in the height of the bumps in typical solder bump arrays becomes the main issue in achieving reliable contact between the bumps and the test bed over the entire bump array. Typically, pressure is applied to the device under test to urge the solder bumps into contact with the test bed. The solder bumps will deform slightly and enable small differences in bump height to be overcome. However, bump height variation in ball grid arrays and solder bump arrays often exceeds the amount of offset that can be compensated for with applied pressure.

### Statement Of The Invention

We have developed a method for testing solder ball or bump test apparatus for either singulated IC devices or wafers that greatly reduces the pressure required to bring all bumps in the IC array into contact with the test array. The method involves reshaping the solder balls in the array so that the contact surfaces of all of the balls in the array are coplanar and a uniform offset is produced between the contact surface of the solder balls and the IC substrate. The reshaped solder balls have a cross section of a truncated sphere, i.e. the apex of the sphere is replaced by a planar section. The solder ball array is then ideally suited for contacting a planar test bed, or bonding to an interconnect substrate. It is also suited for mounting in a test apparatus with recessed sockets. In preferred embodiments the sockets are formed by intersecting grooves in the surface of the flat bed. When paired or tripled V-grooves are used, and the grooves made to overlap, then one or more pyramids form at the intersections of paired or tripled grooves. The point of the pyramid(s) at the bottom of the socket becomes a main bearing feature to provide reliable electrical contact to solder balls that have been reshaped and flattened according to the invention.

### Brief Description Of The Drawing

Fig. 1 is a schematic view of a solder bump device under test in a test bed apparatus;
Fig. 2 is a plan view of the array of pads forming the test bed of Fig. 1;
Fig. 3 is a schematic view illustrating the problem in making uniform contact between the array of contact pads and an array of solder bumps with different bump height;
Fig. 4 is a diagram representing a solution, according to the invention, to non-uniform solder bump height;
Fig. 5 is a diagram similar to that of Fig. 4 showing the solder bump array with planarized contact height;
Fig. 6 is a diagram showing the planarized solder bump array contacting a test bed;
Figs. 7-10 are diagrams illustrating an alternative method for planarizing the solder bump array;
Figs. 11 and 12 views illustrating a principle of test bed construction for test beds adapted for use in combination with the flattened solder bumps of the invention;
Figs. 13-15 show an array of test sockets using pairs of overlapping grooves;
Fig. 16 shows a test bed with sockets formed at the intersections of sets having three grooves showing contact points in the socket that are adapted to contact the flattened solder bump arrays of the invention;
Figs. 17 and 18 show plan and section views respectively of an array of test bed sockets similar to that shown in Fig. 16 but provided with through holes for efficient interconnection;
Fig. 19 is a schematic representation of the application of the test apparatus of the invention to wafer scale testing; and
Fig. 20 is a view of a test bed apparatus of the invention adapted for multichip module packages.

### Detailed Description

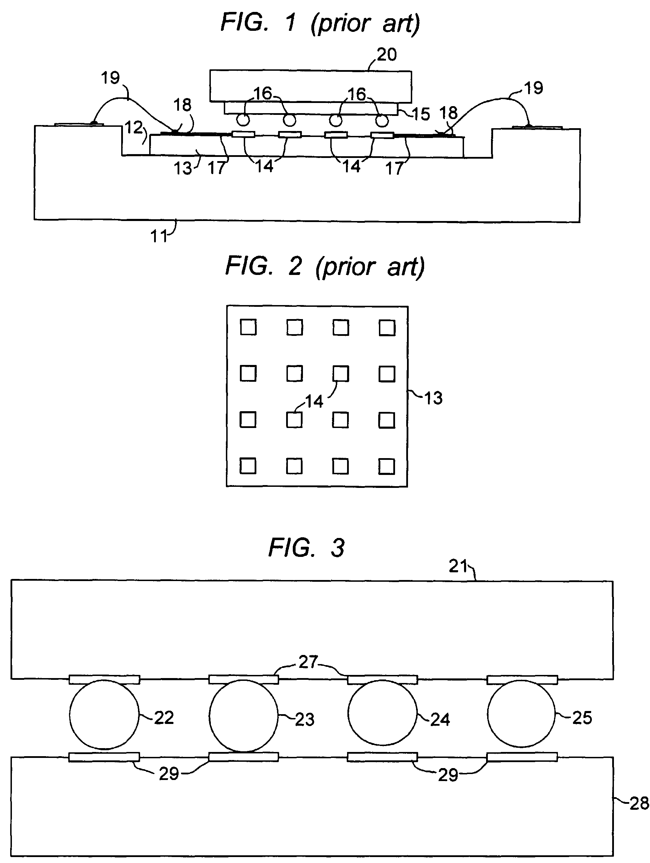

Referring to Fig. 1 a conventional IC test apparatus is shown with base 11, and recess 12 in the base for supporting silicon test bed 13. The test bed is provided with an array of contact pads 14 for contacting the solder bumps on the device under test. A typical solder bumped IC chip is shown at 15, inverted to mate the array of solder bumps 167 with pad 14. Printed interconnections 17 are formed on the upper surface of the test bed for interconnecting the contact pads 14 with bonding pads 18. The bonding pads are wire bonded to the base member with wire bonds 19 to interconnect the IC to a test circuit (not shown). It will be understood by those skilled in the art that, for simplicity in illustration, only a few solder bumps are shown in these figures. Typically there will be dozens or even hundreds of solder bumps to be interconnected for test.

The pitch of contact pads for a bumped IC chip in current technology is of the order of 50-800 µm and the spacing between pads may be 20-350 µm. The bumps are typically 15-250 µm in height (z-direction). The device package is usually square or rectangular with sides typically in the 2-50 mil range.

The IC device to be tested is mounted in place on the test bed by aligning the solder bumps array with the pads on the test bed. The placing of the IC device on the test bed is accomplished with a pick and place alignment tool. Once placed in proper alignment, the IC device is held in place for testing by block 24, which is also used to apply pressure uniformly to the IC and ensure contact between solder bumps 16 and contact pads 14 over the entire array.

The array of pads in Fig. 1 is shown in plan view in Fig. 2. Here contact pads 14 are formed on test bed 13 by printing the pads, and an interconnect circuit (not shown here but represented by 17 in Fig. 1), by standard lithographic or screen printing techniques. Photolithography can be used to form precisely spaced arrays.

The problem introduced by varying solder bump height is illustrated in Fig. 3. Here the solder bump IC device is shown at 21 with solder bumps 22-25 attached to the IC using under bump metallization 27. A planar test bed is shown at 28 with test contact pads 29 aligned to the array of solder bumps as shown. As is evident, the solder bumps are not precisely uniform in size or height. A variation in height of 2-30 microns is typical. When solder bump 23 contacts the test bed, solder bumps 22, 24 and 25 are not in contact. Solder bump 23 will deform slightly under pressure applied via block 20 (Fig. 1), but frequently not enough to bring all of the bumps in the array into reliable contact.

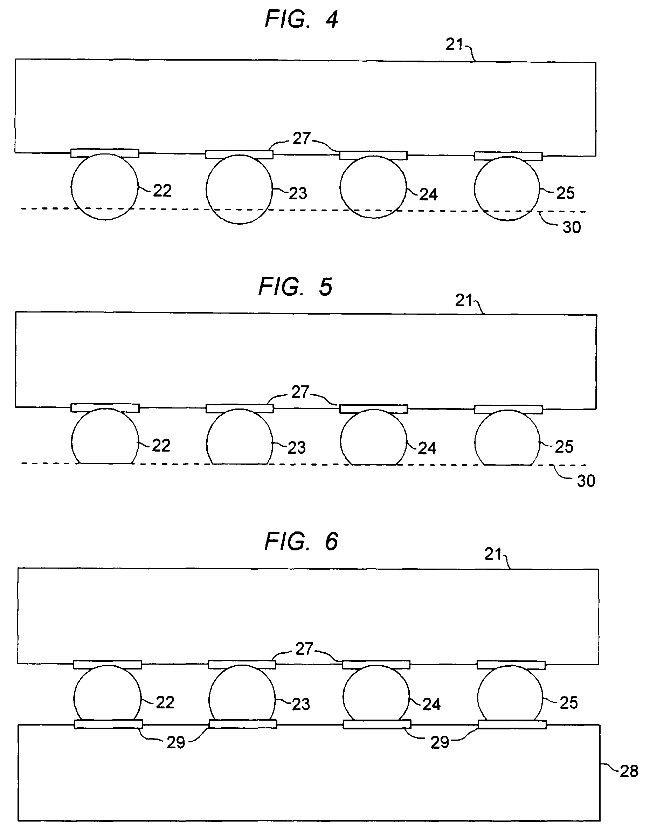

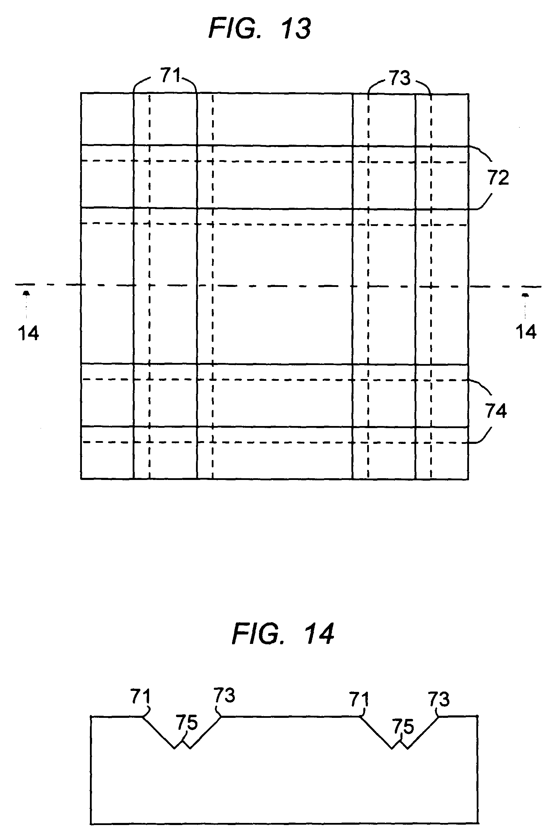

With reference to Fig. 14, the solder bumps are reshaped so that the contact surfaces of the solder bump array are coplanar along dotted line 30. This result is achieved by removing the material below the line 30 to produce the structure shown in Fir. 5 Alternatively, the solder balls can be reshaped to produce the structure of Fig. 5. After flattening the solder balls in the array, the coplanar flattened solder bumps uniformly contact the test bed as shown in Fig. 6.

A preferred technique for reshaping the solder bumps is by mechanically removing or abrading away the tops of the balls. A convenient tool for achieving this is a dicing saw. This tep is preferably performed at the wafer level. Dicing equipment is highly developed and widely available. The depth of cut of the saw blade (z-direction) in such equipment can be very accurately controlled, as well as the x-y position of the cut itself. The saw cut is represented by dashed line 30 in Fig. 5. Commercially available dicing machines are easily capable of controllably removing solder material to produce the result represented by Figs. 4 and 5.

The kerf of the dicing saw is normally minimized in a typical dicing operation. A width of 40 to 100 µm, is preferred. With the high precision of typical dicing machines it is not essential to cut full widths of solder balls in a given pass, i.e. slight overlap can be used making the relationship between the kerf, and the size and pitch of the solder bumps, non-critical.

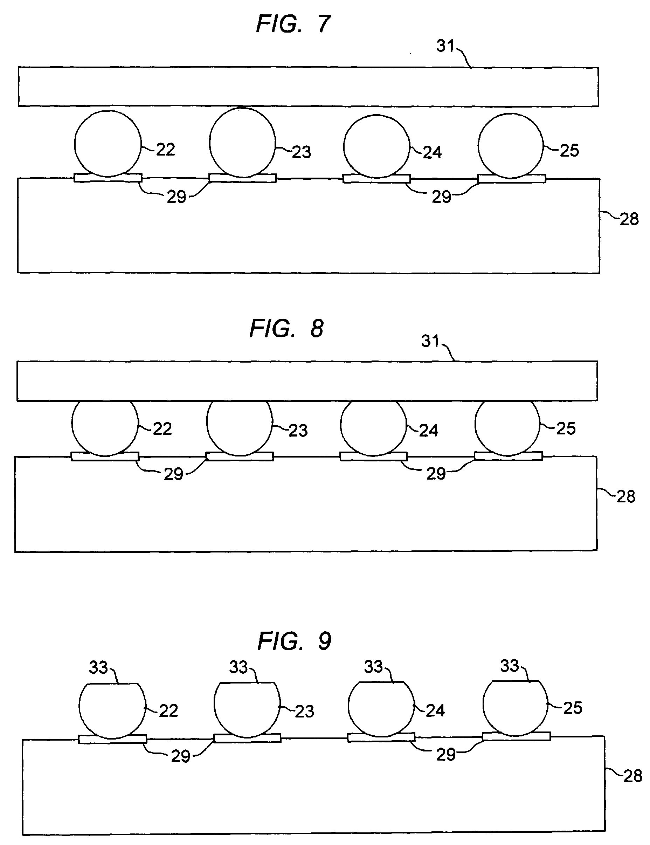

An alternative technique for shaping the solder bumps is to remold the bumps using a non-wetting mold. This technique is illustrated by Figs. 7-10. In Fig. 7, a highly planar leveling element 31 is shown in position to contact the array of solder bumps 22-25. The solder bumps are then heated to at least the solder softening point, and the leveling element 31 is urged to a position shown in Fig. 8. The planar leveling element 31 may be a ceramic wafer, or may be a silicon wafer, or an oxidized silicon waver. The planar surface of the leveling element 31 should be of a material that does not wet with solder. A non-wetting surface is a commonly understood properly and can be defined more specifically as a surface to which a material placed in contact therewith does not adhere. In the context of a lead or tin based solder it means that when a surface is exposed to molten solder, and the solder solidifies, essentially no solder remains on the surface when the solid solder is pulled way, e.g. using a standard pull test. Examples of surfaces that do not wet with lead or tin base solders are *Sio*₂, *Al*₂*O*₃, and Cr.

Solder used for solder bumps in conventional IC technology is typically a lead based or tin based solder with a melting point in the range 130-310°C. Examples are given in the following table.

**TABLE 1**

| composition | Sn | Pb | Bi | solidus °C | liquidus °C |
|---|---|---|---|---|---|
| I | 63 | 37 | | 183 | 183 |
| II | 5 | 95 | | 305 | 310 |
| III | 42 | | 58 | 138 | 138 |
| IV | 43 | 43 | 14 | 143 | 163 |

The solder may be heated by placing the assembly of Fig. 7 in a furnace, or on a hot plate. Alternatively the leveling element 31 can be heated, for example, a hot knife can be used. The entire solder bump may be melted in this step in which case it retains the bump shape by surface tension. The solder bumps are then cooled with the leveling element 31 in position as shown in Fig. 8. After the solder bumps solidify the leveling element 31 is removed and the solder bump array is planarized as shown in Fig. 9.

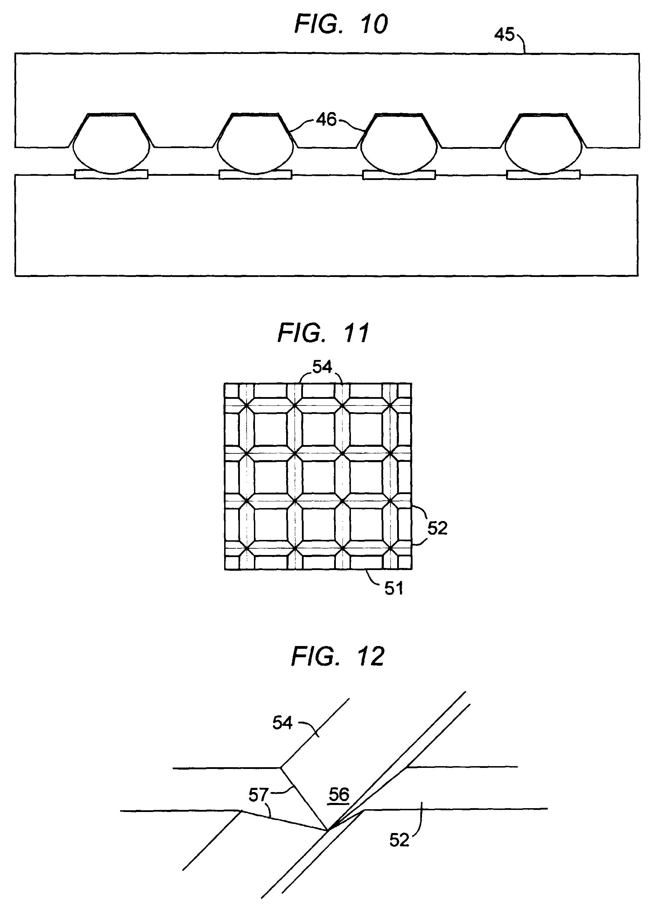

The leveling element can also be provided with mold sites to shape the solder bumps as well as flatten them. Such a leveling element is shown at 45 in Fig. 10. The sidewalls of mold 46 are sloped producing a taper in the solder bump. Tampered solder bumps are especially useful when testing with an array of sockets as will now be described. The taper aids in matching the solder bump array to the socket array of the test bed.

An improved test bed structure can further aid in insuring reliable and uniform contact between test contacts and the solder bumps of the solder bump array. The principle of this improved test bed is illustrated by Figs. 11 and 12. The test bed is grooved in orthogonal directions to form sockets at the intersection of the grooves. In Fig. 11, the test bed 51 is shown with grooves 52 extending the x-direction, and grooves 54 extending in the y-direction. The socket formed by intersecting grooves can be seen in more detail in Fig. 12, which is a cutaway portion of the test bed of Fig. 11, showing a single socket. The V-groove 52 intersects V-grooves 54 forming socket 56 which comprises essentially the four edges 57. These edges are relatively sharp and make effective contact with solder bumps placed in the socket.

The material of the test bed is preferably hard, e.g. ceramic or silicon. The V-grooves may be formed by any suitable technique. In the case of ceramic, the V-grooves are preferably formed using a conventional dicing saw apparatus with a V-shaped blade. In the case of silicon, the V-groove may be etched, using photolithography to selectively etch the grooves where desired. However, the preferred choice in the case of silicon is to cut the grooves using a dicing tool as just mentioned. The shape of the groove can be varied. An essentially pure V-groove is relatively simple to construct. Alternatively, grooves with a flattened bottom may be formed using a saw blade with an inverted truncated pyramid. This option may be especially useful where the test bed is provided with through holes as will be described later.

The socket formed at the intersection of the orthogonal V-grooves is plated with metal, and the array of sockets is interconnected with a printed circuit in a suitable manner, e.g. as described in connection with Fig. 1. Where a silicon wafer is used as the test bed, the V-grooves are provided with an oxide or other insulating coating prior to plating the sockets. The term plating is used here to describe any selective area deposition technique. The insulating layer is preferably formed by growing or depositing SiO₂. A suitable processing sequence for silicon wafer test beds is:
1. Saw intersecting V-grooves using a dicing saw.
2. Grow a layer of oxide with a thickness of, e.g. 0.25-1.5 µm oxide on the grooved substrate and extending into the V-grooves.
3. Blanket deposit a conductive metal layer on the wafer.
4. Selectively etch the conductive metal layer to leave an interconnect pattern on the silicon wafer test bed and coat the sockets formed at the intersection of the V-grooves.

The metal used in step 3 may be aluminum but is preferably a hard metal such as Ni, Au or Au-Pd so that the edges of the socket remain sharp. The metal may cover the entire socket, or part of the socket as long as one or more edges are covered.

The sockets are preferably formed at the intersection of orthogonal grooves. However, useful sockets with appropriately sharp edges can be formed with grooves intersecting at angles other than 90°. Useful sockets may also be formed using more than two intersecting grooves, i.e. multiple grooves intersecting at different angles. This expedient can produce star shapes in which the socket may comprise six or eight contact edges. The shape of the groove may also be varied. V-grooves are convenient to produce, but other groove shapes, even rectangular grooves, may be found useful. The preferred groove angle as measured from wall to wall is 90° +/- 30°. The depth of the groove should be at least 30%, and preferably at least 40% of the diameter of the solder bumps on the IC devices inserted into the test bed.

An alternative procedure for forming the V-grooved test bed using a single crystal silicon wafer is the following:
1. Grow an oxide layer 0.25-1.5 µm on the Si wafer.
2. Lithographically form a V-groove mask on the oxide, preferably by applying and patterning a photoresist layer.
3. Etch the oxide with a standard HF etch to leave the desired V-groove pattern on the silicon wafer.
4. Etch the exposed silicon using a crystallographic etch, e.g. 20% NaOH in water, to etch the silicon wafer along crystallographic planes that intersect in a V, thus producing V-grooves in the V-groove pattern of step 3.
5. Regrow oxide on the exposed silicon in the V-grooves.
6. Blanket deposit a conductive metal layer on the wafer.
7. Selectively etch the conductive metal layer to leave an interconnect pattern on the silicon wafer test bed and coat the sockets formed at the intersection of the V-grooves.

Another option according to the invention is to use a polysilicon wafer as the test bed material. A suitable process sequence is:
1. Grow an oxide layer 0.25 to 1.5 µm on the polysilicon wafer.
2. Lithographically form a V-groove mask on the oxide, preferably by applying and patterning a photoresist layer.
3. Etch the oxide with a standard HF etch to leave the desired V-groove pattern on the silicon wafer.
4. Etch the exposed silicon using an isotropic etch, e.g. 20% NaOH in water, to etch the silicon wafer and undercut the mask, thus producing V-grooves in the V-groove pattern of step 3.
5. Regrow oxide on the exposed silicon in the V-grooves.
6. Blanket deposit a conductive metal layer on the wafer.
7. Selectively etch the conductive metal layer to leave an interconnect pattern on the silicon wafer test bed and on the sockets formed at the intersection of the V-grooves.

Suitable grooved structures can also be produced in both polysilicon and single crystal silicon using a photoresist mask for the V-groove etch step.

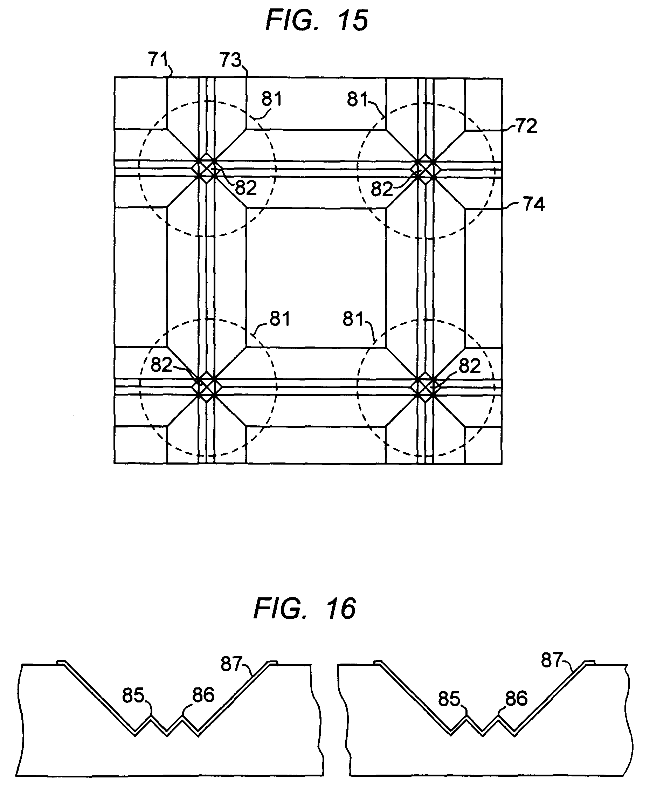

The V-groove principle for forming sockets as described above can be used to advantage to produce a test bed with an array of unique sockets particularly suited for the flattened array of solder balls described in detail earlier. This preferred test bed is shown in Figs. 13-15. Here pairs of parallel grooves are used to form sharp contact surfaces in the bottom of the socket. Referring to Fig. 13, the boundaries of a first set of y-direction grooves are indicated at 72. The second set of grooves is shown with dashed lines in Fig. 13. The second set of grooves is made overlapping the first set. The boundaries of a second set of y-direction grooves are indicated at 73 and the boundaries of a second set of x-direction grooves are indicated at 74. After the grooves are formed, the profile of the test bed with overlapping pairs of V-grooves is shown in Fig. 14, which is a section through 14-14 of Fig. 13. The boundaries 71 and 73 remain after the overlapping grooves are formed. At the bottom of the overlapping pair of grooves a ridge 74 forms. The height of the ridge as a percentage of the depth of the groove is equal to the percentage overlap of the pair of grooves, It is preferred that this percentage be in the range 5-40%. The profile of Fig. 14 shows only the y-direction grooves. Fig. 15 shows the boundaries of both sets of grooves, i.e. 71 and 73 of the y-direction grooves and 72 and 74 of the x-direction grooves. The sockets are shown at 81 and each socket has a pyramid 82 formed in the bottom of the socket. This pyramid has a sharp top which, as discussed earlier, presents an effective contact point to enhance the electrical contact between the socket and the flattened solder bump contacts.

When silicon wafers are grooved according to the invention and the grooves are relatively deep the wafers may tend to fracture along the groove line. Accordingly, it may be desirable, prior to the grooving step, to laminate the wafers to another substrate, e.g. ceramic, or add another silicon wafer as a laminate. The wafer can be laminated using a conventional organic adhesive.

Having shown the effect of overlapping a pair of grooves, it will occur to those skilled in the art that more than two parallel grooves can be used to form the sockets. Fig. 16 shows a cross section of a test bed in which three overlapping parallel grooves are used in each groove set. In this case two ridges, 85 and 86, form at the bottom of the groove set. At the intersection of two sets of three parallel grooves, a set of four pyramids will form. The points of the four pyramids, metallized with metal layer 87, provide a reliable contact bearing surface especially when used with flattened array of solder bumps. The space between the edges of the socket is relatively unimportant, and the socket array can be used for different sized solder balls, as long as the pitch of the solder ball array is the same.

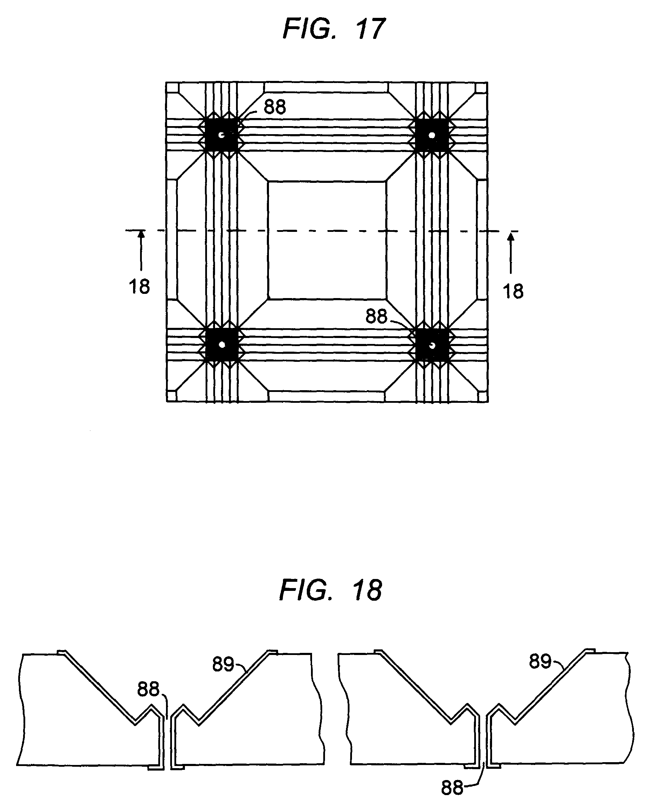

A preferred embodiment of the invention with a highly efficient interconnect strategy is shown in Figs. 17 and 18. With reference to Fig. 17, the sockets formed by intersecting grooves are provided with through hole interconnections 88 and metallization 89 covering at least the sharp features in the socket, and the through hole. The test bed is shown in cross section in Fig. 18, which is a section through 18-18 of Fig. 17. The through hole interconnections allow the test signals from the solder bumps of the IC under test to flow directly through the test bed to the test circuit on the next board level, thereby substantially reducing parasitics in the test signals.

Through holes may be provided in ceramic test beds in the conventional manner by drilling the ceramic and through plating the holes. Through holes in ceramic may also be formed using co-fired ceramic. This known technique allows the holes to be accurately formed and plated with, e.g., tungsten plugs, in the co-firing operation. Through holes may be provided in silicon wafers by known methods such as laser drilling the holes, oxidizing the holes and depositing metal on the oxide. A suitable technique for forming the conductor material in the through holes is by metal sputtering or electroless plating.

A universal test bed can be constructed using the principles described above by providing an array of solder ball sockets on one side of the test bed, and an array of interconnection sites on the other side of the test bed. A key ingredient of this approach is the use of plated through holes as described in connection with Figs. 17 and 18. The interconnection array is adapted to be interconnected to the next board level, e.g. a silicon, ceramic, or epoxy interconnection substrate. The interconnection circuit at the next board level is tailored to the IC to be tested. Sockets and interconnection sites on the universal test bed that are not interconnected remain but are not used. The advantage of the universal test bed approach is that the socket part of the test apparatus can be made in volume at relatively low cost. A batch of universal test bed wafers can be made for each commonly used pitch, and can even be made with arrays on different pitch.

IC devices for which the test apparatus of this invention is suitable are unpackaged chips or chip scale packages with solder bump or ball grid arrays. The I/O contacts may be perimeter or area arrays in which the solder bumps/balls are raised off the IC surface, typically by more than 10 µm, to as much as 100 µm, or even 500 µm in the case of some ball grid arrays.

The step of electrically testing the IC devices according to the invention involves the application of test voltages to selected I/O sockets of the test bed through the test interconnection substrate. Thus in a typical manufacturing operation using the invention, IC devices would be conveyed from the singulation or packaging operation to a placement tool, then individually placed with the solder bumps or ball grid aligned to the socket array. The interconnection circuit used for the test can be an identical replica of the interconnection circuit on which the IC devices are permanently mounted. The test bed can also be the actual interconnection substrate to which an IC device that passes the electrical test is permanently bonded.

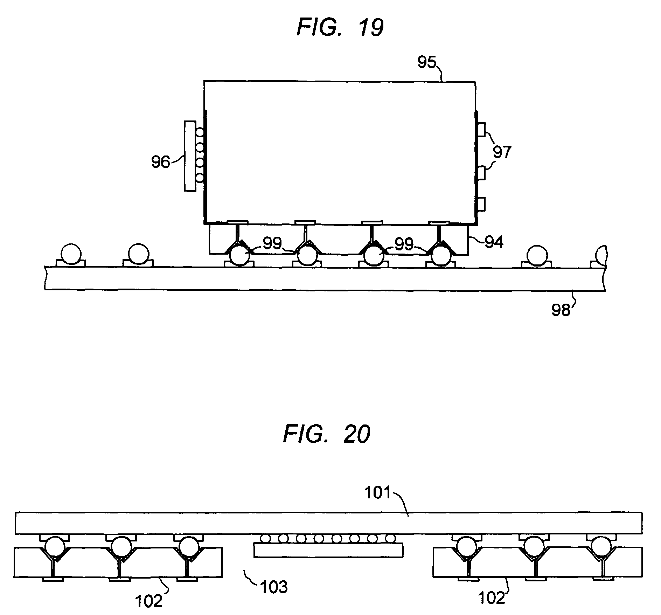

The reshaped solder bumps according to the invention are preferably produced at the wafer level. However, the individual IC devices can be tested at either the wafer level or after singulation. Wafer level testing usually involves testing individual IC devices before dicing. A wafer scale testing apparatus is shown in Fig. 19. The test bed 94 described above is easily mounted on the head 95 of a placement tool. The placement tool head may also be provided with test circuits and passive components indicated schematically at 96 and 97. A wafer under test is shown at 98 with four flattened solder bumps 99 representing one IC device, or a portion of an IC device, on wafer 98 prior to singulation.

The test apparatus of the invention can be used with multi-chip modules. Fig. 20 shows a recessed chip MCM package 101 mounted for test on test bed 102. In this application the test bed is provided with an opening 103 to accommodate the recessed chip. The term IC device as used herein is intended to include packages containing one or more IC chips.

The electrical test procedure itself is conventional and comprises the steps of applying test voltages to the array of electrical test contacts, measuring the test voltages, comparing the measured test voltages to a set of predetermined IC device voltages, and selecting those IC devices with test voltages that meet said set of predetermined IC device voltages for final assembly, i.e. bonding the IC device to a permanent interconnection substrate. As will be understood by those skilled in the art the steps of measuring, comparing and selecting are carried out by automated software driven means.

Whereas any degree of flattening of the solder bumps in a solder bump array will improve the contact resistance when the array is placed on a test bed, or mounted in a device package, for the purpose of defining the invention the solder bumps are preferably approximately circular in cross section, and the flat on the solder bump in cross section corresponds to a cord of the circle of the solder bump. The preferred case is where the cord is at least 20% of the diameter of the solder bump. The diameter of a typical solder bump may vary since solder bumps are not precisely circular. Accordingly, if necessary to describe the invention, the preferred case is where a cross section of the flat portion of the solder bump corresponds to a cord that is at least 20% of the diameter of the solder bump as measured parallel to the surface on which the solder bump array is formed. Also for the purpose of defining the invention the term flat is intended to mean flat with preferably relatively high precision, e.g. with surface variations of less than 5%.

Various additional modifications of this invention will occur to those skilled in the art. All deviations from the specific teachings of this specification that basically rely on the principles and their equivalents through which the art has been advanced are properly considered within the scope of the invention as described and claimed.

## Claims

1. A method for electrically testing an IC device, said device having an array of I/O solder bumps on at least one IC surface, the test method comprising:
a. shaping the solder bumps in the array of I/O solder bumps to form an essentially flat surface on the solder bumps,
b. aligning the flat surface of the solder bumps with an array of electrical test contacts on an interconnection substrate, and
c. applying test voltages to said array of electrical test contacts.

2. A method for bonding an IC device to an interconnection substrate, said device having an array of I/O solder bumps on at least one surface thereof, the method comprising:
a. shaping the solder bumps in the array of solder bumps to form an essentially flat surface on the solder bumps.
b. aligning the flat surface of the solder bumps with an array of electrical contact on an interconnection substrate, and
c. heating said array of I/O solder bumps to bond it to said interconnection substrate.

3. The method of claim 1 or 2 in which the solder bumps are shaped by placing the array in contact with a planar surface, heating the solder bumps to at least the softening point of the solder, moving the planar surface toward the IC surface and cooling the solder bumps to solidify the solder bumps thereby forming said flat surface on the solder bumps.

4. The method of claim 1 or 2 in which the solder bumps are shaped by mechanically removing a portion of the solder bumps.

5. The method of claim 4 in which the solder bumps are shaped by sawing off a portion of the solder bumps using a saw.

6. The method of claim 1 or 2 in which the array of electrical test contacts is an array of sockets and the sockets are formed by the intersection of:
a. at least two grooves extending in a first direction and
b. at least two grooves extending in a section direction,
and wherein said at least two grooves overlap whereby each of said sockets has at least one pyramid in the bottom of the socket.

7. The method of claim 6 wherein the said grooves are V-grooves.

8. The method of claim 7 in which said at least two grooves overlap by 5-40%.

9. The method of claim 6 in which the said sockets are provided with through hole intersections through said interconnection substrate.

10. An IC device comprising an array of I/O solder bumps on at least one surface of said IC device, said solder bumps having a cross section of a truncated sphere.

11. The IC device of claim 10 wherein the truncated portion of the sphere is at least 20% of the diameter of the sphere.
